# EUROPEAN PATENT APPLICATION

(11) **EP 4 841 316 A1**
(43) Date of publication of application: **18.11.2026**
(21) Application number: 25738762.1
(22) Date of filing: 07.01.2025
(51) Int. Cl.: G02B 6/12, C08F 2/44, C08F 290/00, C08G 59/40

(54) **PHOTOSENSITIVE RESIN COMPOSITION FOR OPTICAL WAVEGUIDE, PHOTOSENSITIVE RESIN FILM, OPTICAL WAVEGUIDE, AND PHOTOELECTRIC COMPOSITE SUBSTRATE**

(30) Priority: 12.01.2024 JP 2024003395
(71) Applicant: Resonac Corporation, Tokyo 105-7325 (JP)
(72) Inventor: YOSHIDA, Yuma, Tokyo 105-7325 (JP); SAKAMOTO, Taiga, Tokyo 105-7325 (JP)
(74) Representative: Hoffmann Eitle
(86) International application number: PCT/JP2025/000215
(87) International publication number: WO 2025/150494

(57) **Abstract**

A photosensitive resin composition for an optical waveguide, in which an integrated value of absorbance at wavenumbers of from 9090 cm⁻¹ to 10526 cm⁻¹ at a thickness of 1 mm is 3.00 or less.

## Description

### Technical Field

The present disclosure relates to a photosensitive resin composition for an optical waveguide, a photosensitive resin film, an optical waveguide, and an optoelectronic composite substrate.

### Background Art

Forming an optical waveguide by curing a composition containing a resin component has been studied. Production of a polymer optical waveguide structure in which an optical waveguide is provided inside a resin layer including a lower cladding layer, a core layer, and an upper cladding layer has been studied because the production process can be simplified, and low cost and high functionality can be achieved. For example, forming an optical waveguide by curing a photosensitive resin composition for an optical waveguide containing a resin component and a photopolymerization initiator has been proposed (see, for example, Patent Literature 1).

### PRIOR ART DOCUMENT

### Patent Literature

Patent Literature 1: Japanese Patent No. 6344792

### SUMMARY OF INVENTION

### Technical Problem

In Patent Literature 1, an object is to achieve low loss by avoiding vibrational absorption originating from a resin backbone at 850 nm propagation light in an optical waveguide, through the use, as a resin component, of a resin component having a low absorbance with respect to a range of from 3000 to 2800 cm⁻¹, which is C-H bond vibrational absorption, particularly 2960 cm⁻¹ in an IR spectrum.

However, in Patent Literature 1, an optical waveguide capable of reducing the transmission loss at 1310 nm has not been studied.

An object of the present disclosure is to provide a photosensitive resin composition for an optical waveguide for use in forming an optical waveguide capable of reducing a transmission loss at 1310 nm, and a photosensitive resin film, an optical waveguide, and an optoelectronic composite substrate using the photosensitive resin composition.

### Solution to Problem

<1> A photosensitive resin composition for an optical waveguide, in which an integrated value of absorbance at wavenumbers of from 9090 cm⁻¹ to 10526 cm⁻¹ at a thickness of 1 mm is 3.00 or less.
<2> The photosensitive resin composition for an optical waveguide according to <1>, including a compound (A) containing an acidic group in one molecule.
<3> The photosensitive resin composition for an optical waveguide according to <1> or <2>, including a compound (B) containing an ethylenically unsaturated group.
<4> The photosensitive resin composition for an optical waveguide according to any one of <1> to <3>, including a compound (C) containing an epoxy group.
<5> The photosensitive resin composition for an optical waveguide according to any one of <1> to <4>, including a polymerization initiator (D).
<6> The photosensitive resin composition for an optical waveguide according to any one of <1> to <5>, including a maleimide compound (E).
<7> A photosensitive resin film including a photosensitive resin layer formed from the photosensitive resin composition for an optical waveguide according to any one of <1> to <6>.
<8> A photosensitive resin film including:
   a base material film layer; and
   a photosensitive resin layer disposed on the base material film layer and formed from the photosensitive resin composition for an optical waveguide according to any one of <1> to <6>.
<9> A photosensitive resin film including, in this order:
   a base material film layer;
   a photosensitive resin layer formed from the photosensitive resin composition for an optical waveguide according to any one of <1> to <6>; and
   a protective film layer.
<10> An optical waveguide, in which at least one selected from the group consisting of a lower cladding layer, a core layer, and an upper cladding layer is formed from the photosensitive resin composition for an optical waveguide according to any one of <1> to <6>.
<11> An optical waveguide, in which at least one selected from the group consisting of a lower cladding layer, a core layer, and an upper cladding layer is formed from the photosensitive resin film according to <7>.
<12> An optoelectronic composite substrate including the optical waveguide according to <10>.
<13> An optoelectronic composite substrate including the optical waveguide according to <11>.

### Advantageous Effects of Invention

According to the present disclosure, it is possible to provide a photosensitive resin composition for an optical waveguide for use in forming an optical waveguide capable of reducing a transmission loss at 1310 nm, and a photosensitive resin film, an optical waveguide, and an optoelectronic composite substrate using the photosensitive resin composition.

### BRIEF DESCRIPTION OF DRAWINGS

Fig. 1A is a schematic cross-sectional view illustrating an embodiment of a semiconductor package according to the present disclosure.
Fig. 1B is a schematic cross-sectional view illustrating an embodiment of a semiconductor package according to the present disclosure.
Fig. 2 is a schematic plan view of the semiconductor package illustrated in Fig. 1A.

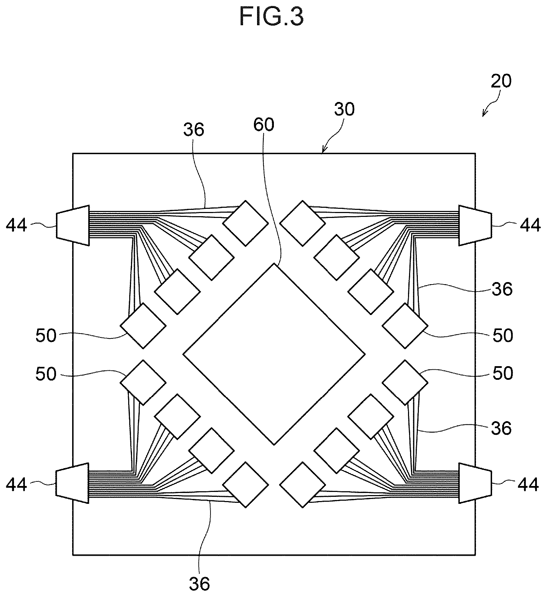

Fig. 3 is a schematic plan view of a modification example of the semiconductor package illustrated in Fig. 1A.
Fig. 4 is a schematic cross-sectional view illustrating another embodiment of the semiconductor package according to the present disclosure.
Fig. 5 is a schematic plan view of the semiconductor package illustrated in Fig. 4.
Fig. 6 is a schematic plan view of a modification example of the semiconductor package illustrated in Fig. 4.
Fig. 7 is a schematic cross-sectional view illustrating another embodiment of the semiconductor package according to the present disclosure.
Fig. 8 is a schematic plan view of the semiconductor package illustrated in Fig. 7.
Fig. 9 is a schematic cross-sectional view illustrating another embodiment of the semiconductor package according to the present disclosure.
Fig. 10 is a schematic cross-sectional view illustrating another embodiment of the semiconductor package according to the present disclosure.
Fig. 11 is a schematic plan view of the semiconductor package illustrated in Fig. 10.
Fig. 12 is a schematic cross-sectional view illustrating another embodiment of the semiconductor package according to the present disclosure.
Fig. 13 is a schematic cross-sectional view illustrating another embodiment of the semiconductor package according to the present disclosure.
Fig. 14 is a perspective view illustrating an optical input portion of an optical circuit chip used in the semiconductor package illustrated in Fig. 1.
Fig. 15 is a perspective view illustrating a modification example of an optical input portion f an optical circuit chip used in the semiconductor package illustrated in Fig. 1.
Fig. 16A is a schematic cross-sectional view illustrating an embodiment of a method of manufacturing an optoelectronic composite wiring board.
Fig. 16B is a schematic cross-sectional view illustrating an embodiment of the method of manufacturing an optoelectronic composite wiring board.
Fig. 16C is a schematic cross-sectional view illustrating an embodiment of the method of manufacturing an optoelectronic composite wiring board.
Fig. 16D is a schematic cross-sectional view illustrating an embodiment of the method of manufacturing an optoelectronic composite wiring board.
Fig. 16E is a schematic cross-sectional view illustrating an embodiment of the method of manufacturing an optoelectronic composite wiring board.
Fig. 16F is a schematic cross-sectional view illustrating an embodiment of the method of manufacturing an optoelectronic composite wiring board.
Fig. 16G is a schematic cross-sectional view illustrating an embodiment of the method of manufacturing an optoelectronic composite wiring board.
Fig. 16H is a schematic cross-sectional view illustrating an embodiment of the method of manufacturing an optoelectronic composite wiring board.
Fig. 16I is a schematic cross-sectional view illustrating an embodiment of the method of manufacturing an optoelectronic composite wiring board.
Fig. 17 is a front view illustrating a material used in a method of manufacturing an optoelectronic composite wiring board.
Fig. 18 is a schematic cross-sectional view illustrating a laminated film used in a method of manufacturing an optoelectronic composite wiring board.
Fig. 19 is a schematic cross-sectional view illustrating a laminated film used in a method of manufacturing an optoelectronic composite wiring board.
Fig. 20 is a schematic cross-sectional view illustrating a laminated film used in a method of manufacturing an optoelectronic composite wiring board.

### DESCRIPTION OF EMBODIMENTS

Hereinafter, embodiments for implementing the present disclosure will be described in detail. However, the present disclosure is not limited to the following embodiments. In the following embodiments, the components (also including element steps and the like) are not essential unless otherwise specified. The same applies to numerical values and ranges thereof, and these do not limit the present disclosure.

In the present disclosure, the term "step" includes not only a step independent of other steps but also a step that cannot be clearly distinguished from other steps as long as the purpose of the step is achieved.

In the present disclosure, a numerical range indicated by "to" includes numerical values described before and after "to" as the minimum value and the maximum value, respectively.

In the numerical ranges described in a stepwise manner in the present disclosure, the upper or lower limit value stated in one numerical range may be replaced with the upper or lower limit value of another numerical range stated in a stepwise manner. In the numerical range described in the present disclosure, the upper limit or lower limit value of the numerical range may be replaced with a value shown in the Examples.

In the present disclosure, each component may include multiple kinds of substances corresponding thereto. In a case in which multiple kinds of substances corresponding to each component are present in the composition, the content or amount of the each component means the total content or amount of the multiple kinds of substances present in the composition, unless otherwise specified.

In the present disclosure, the term "layer" includes not only a case in which the layer is formed in the entire region but also a case in which the layer is formed only in a part of the region, in a case in which the region where the layer is present is observed.

In a case in which an embodiment is described with reference to the drawings in the present disclosure, a configuration of the embodiment is not limited to the configuration illustrated in the drawings.

In addition, the sizes of members in each drawing are schematic, and the relative relationship between the sizes of the members is not limited thereto.

### <Photosensitive Resin Composition for Optical Waveguide>

A photosensitive resin composition for an optical waveguide of the present disclosure (hereinafter, simply referred to as a "photosensitive resin composition") is a composition in which an integrated value of absorbance at wavenumbers of from 9090 cm⁻¹ to 10526 cm⁻¹ at a thickness of 1 mm is 3.00 or less.

The present inventors have found that the integrated value of absorbance at from 950 nm to 1100 nm, that is, the integrated value of absorbance at wavenumbers of from 9090 cm⁻¹ to 10526 cm⁻¹ is correlated with the ideal transmission loss of a resin layer formed from the photosensitive resin composition at 1310 nm. When the integrated value of absorbance at wavenumbers of from 9090 cm⁻¹ to 10526 cm⁻¹ at the thickness of 1 mm is 3.00 or less, transmission loss at 1310 nm in the optical waveguide can be reduced. The reason for this is presumed as follows, but the present disclosure is not limited to the following presumption. In a near-infrared region after 800 nm such as from 950 nm to 1100 nm, a bond including a hydrogen atom such as C-H, N-H, or O-H absorbs light. A concentration of such an X-H (X is, for example, C, N, or O) bond tends to decrease as the integrated value of absorbance at wavenumbers of from 9090 cm⁻¹ to 10526 cm⁻¹ decreases. As a result, light absorption at 1310 nm is reduced, and transmission loss at 1310 nm in the optical waveguide can be reduced.

In the photosensitive resin composition of the present disclosure, the integrated value of absorbance may be 2.80 or less or 2.50 or less. A lower limit of the integrated value of absorbance is not particularly limited, and may be 1.00 or more or 1.50 or more.

The integrated value of absorbance is determined by measuring a near-infrared absorption spectrum using a sample having a thickness of 1 mm produced using the photosensitive resin composition of the present disclosure. In a case in which the near-infrared absorption spectrum is measured using a sample having a thickness other than 1 mm, the integrated value of the measured absorbance may be converted into the case of a thickness of 1 mm.

The photosensitive resin composition of the present disclosure is a composition for use in forming an optical waveguide, and may be, for example, a composition for use in forming an insulating layer including an optical waveguide therein, or a composition for use in forming at least one of a lower cladding layer, a core layer, or an upper cladding layer.

The components contained in the photosensitive resin composition of the present disclosure are not particularly limited as long as the integrated value of absorbance is 3.00 or less. Hereinafter, components that can be contained in the photosensitive resin composition of the present disclosure will be described. The photosensitive resin composition of the present disclosure is not limited to a composition containing the following components. The following components are optional components of the photosensitive resin composition.

### (Compound (A) Containing Acidic Group in One Molecule)

The photosensitive resin composition of the present disclosure may contain a compound (A) (hereinafter, also simply referred to as a "compound (A)") containing an acidic group in one molecule.

The compound (A) is not particularly limited as long as the compound contains an acidic group in one molecule. Examples of the acidic group include a carboxy group, a sulfonic acid group, and a phenolic hydroxyl group. The number of acidic groups contained in the compound (A) is not particularly limited, and may be one in one molecule or two or more in one molecule.

The compound (A) may be used singly, or in a mixture of two or more kinds thereof.

An acid value of the compound (A) is preferably from 30 mgKOH/g to 150 mgKOH/g, more preferably from 40 mgKOH/g to 120 mgKOH/g, and even more preferably from 50 mgKOH/g to 100 mgKOH/g. In a case in which the acid value of the compound (A) is 30 mgKOH/g or more, solubility of the photosensitive resin composition in a dilute alkaline solution tends to be improved. In a case in which the acid value of the compound (A) is 150 mgKOH/g or less, the integrated value of absorbance at wavenumbers of from 9090 cm⁻¹ to 10526 cm⁻¹ tends to decrease, and thus propagation loss at 1310 nm tends to further decrease.

The compound (A) may be a phenol compound such as a novolac-type phenol resin or a cresol novolac-type phenol resin, or a (meth)acrylate compound containing an acidic group.

In the present disclosure, a compound containing an acidic group and an ethylenically unsaturated group is classified as the compound (A).

In the present disclosure, a compound containing an acidic group and an epoxy group is classified as a compound (C) containing an epoxy group described later.

In a case in which the photosensitive resin composition contains the compound (A), the content of the compound (A) may be from 30% by mass to 85% by mass, from 40% by mass to 80% by mass, or from 50% by mass to 75% by mass with respect to a total amount of the photosensitive resin composition.

In a case in which the compound (A) contains an epoxy compound containing an acidic group, the content of a (meth)acrylate compound containing an acidic group may be from 50% by mass to 100% by mass, from 70% by mass to 100% by mass, or from 90% by mass to 100% by mass with respect to a total amount of the compound (A).

In a case in which the compound (A) contains an epoxy compound containing an acidic group, the content of the epoxy compound containing an acidic group may be from 40% by mass to 85% by mass, from 45% by mass to 80% by mass, or from 50% by mass to 75% by mass with respect to a total amount of the photosensitive resin composition.

### (Compound (B) Containing Ethylenically Unsaturated Group)

The photosensitive resin composition of the present disclosure may contain a compound (B) containing an ethylenically unsaturated group (hereinafter, also simply referred to as a "compound (B)").

The compound (B) is not particularly limited as long as the compound contains one or more ethylenically unsaturated groups in one molecule. Examples of the ethylenically unsaturated group include a (meth)acryloyl group, a (meth)acrylamide group, a styryl group, a (meth)allyl group, and a vinyl group. The number of ethylenically unsaturated groups contained in the compound (B) is not particularly limited, and may be one in one molecule, two or more in one molecule, or two or more and six or less in one molecule.

The compound (B) may be used singly, or in a mixture of two or more kinds thereof.

Examples of the compound (B) include (meth)acrylate compounds, (meth)acrylamide compounds, (meth)allyl compounds, and vinyl compounds, and polyfunctional (meth)acrylate compounds, polyfunctional (meth)acrylamide compounds, polyfunctional (meth)allyl compounds, and polyfunctional vinyl compounds are preferable, and polyfunctional (meth)acrylate compounds are more preferable.

Examples of the polyfunctional (meth)acrylate compound include diethylene glycol di(meth)acrylate, triethylene glycol di(meth)acrylate, tetraethylene glycol di(meth)acrylate, trimethylolpropane di(meth)acrylate, trimethylolpropane tri(meth)acrylate, 1,4-butanediol di(meth)acrylate, 1,6-hexanediol di(meth)acrylate, polyethylene glycol di(meth)acrylate, polypropylene glycol di(meth)acrylate, tricyclodecanedimethylol di(meth)acrylate, ditrimethylolpropane tetra(meth)acrylate, pentaerythritol tri(meth)acrylate, pentaerythritol tetra(meth)acrylate, dipentaerythritol hexa(meth)acrylate, dipentaerythritol hexa(meth)acrylate, tris(2-(meth)acryloyloxyethyl) isocyanurate, tri(meth)acrylate of tris (β-hydroxyethyl) isocyanurate, polycarbonate diol di(meth)acrylate, and urethane (meth)acrylate.

Examples of the polyfunctional (meth)acrylamide compound include N,N'-methylenebis(meth)acrylamide, N,N'-ethylenebis(meth)acrylamide, N,N'-(1,2-dihydroxyethylene)bis(meth)acrylamide, and N-[tris(3-acrylamidopropoxymethyl)methyl](meth)acrylamide.

Examples of the polyfunctional (meth)allyl compound include di(meth)allyl benzene dicarboxylate, di(meth)allyl cyclohexane dicarboxylate, di(meth)allyl maleate, di(meth)allyl adipate, di(meth)allyl phthalate, di(meth)allyl isophthalate, di(meth)allyl terephthalate, glycerin di(meth)allyl ether, trimethylolpropane di(meth)allyl ether, pentaerythritol di(meth)allyl ether, pentaerythritol tri(meth)allyl ether, tri(meth)allyl cyanurate, tri(meth)allyl isocyanurate, tri(meth)allyl trimellitate, tetra(meth)allyl pyromellitate, 1,3,4,6-tetra(meth)allyl glycoluril, 1,3,4,6-tetra(meth)allyl-3a-methylglycoluril, and 1,3,4,6-tetra(meth)allyl-3a,6a-dimethylglycoluril.

Examples of the polyfunctional vinyl compound include divinylbenzene, divinylnaphthalene, divinylbiphenyl, divinylcyclohexane, cyclohexanedimethanol divinyl ether, and polybutadiene.

In a case in which the photosensitive resin composition contains the compound (B), the content of the compound (B) may be from 5% by mass to 60% by mass, from 10% by mass to 55% by mass, from 12% by mass to 50% by mass, from 15% by mass to 45% by mass, or from 18% by mass to 40% by mass with respect to a total amount of the photosensitive resin composition.

In a case in which the compound (B) contains a polyfunctional (meth)acrylate compound, the content of the polyfunctional (meth)acrylate compound may be from 30% by mass to 100% by mass, from 50% by mass to 100% by mass, from 70% by mass to 100% by mass, or from 90% by mass to 100% by mass with respect to a total amount of the compound (B).

In a case in which the photosensitive resin composition contains a (meth)acrylate compound containing an acidic group as the compound (A), the photosensitive resin composition preferably contains the compound (B), and preferably contains a polyfunctional (meth)acrylate compound as the compound (B).

In a case in which the photosensitive resin composition contains a phenol compound as the compound (A), the photosensitive resin composition may or may not contain the compound (B).

### (Compound (C) Containing Epoxy Group)

The photosensitive resin composition of the present disclosure may contain a compound (C) containing an epoxy group (hereinafter, also simply referred to as a "compound (C)").

The compound (C) is not particularly limited as long as the compound contains one or more epoxy groups in one molecule. The number of epoxy groups contained in the compound (C) is not particularly limited, and may be one in one molecule or two or more in one molecule.

The compound (C) may be used singly, or in a mixture of two or more kinds thereof.

Examples of the compound (C) include a novolac-type epoxy resin (such as a phenol novolac-type epoxy resin or an o-cresol novolac-type epoxy resin) obtained by epoxidizing a novolac resin obtained by condensing or co-condensing at least one phenolic compound selected from the group consisting of phenol compounds such as phenol, cresol, xylenol, resorcin, catechol, bisphenol A, and bisphenol F and naphthol compounds such as α-naphthol, β-naphthol, and dihydroxynaphthalene with an aliphatic aldehyde compound such as formaldehyde, acetaldehyde, or propionaldehyde under an acidic catalyst; a triphenylmethane-type epoxy resin obtained by epoxidizing a triphenylmethane-type phenol resin obtained by condensation or co-condensation of the phenolic compound with an aromatic aldehyde compound such as benzaldehyde or salicylaldehyde under an acidic catalyst; a copolymerized epoxy resin obtained by epoxidizing a novolac resin obtained by co-condensing the phenol compound and the naphthol compound with an aldehyde compound under an acidic catalyst; a diphenylmethane-type epoxy resin, which is a diglycidyl ether such as bisphenol A or bisphenol F; a hydrogenated epoxy resin obtained by hydrogenating a diglycidyl ether such as bisphenol A or bisphenol F; a biphenyl-type epoxy resin, which is a diglycidyl ether of alkyl-substituted or unsubstituted biphenol; a stilbene-type epoxy resin, which is a diglycidyl ether of a stilbene-based phenol compound; a sulfur atom-containing epoxy resin, which is a diglycidyl ether such as bisphenol S; an epoxy resin, which is a glycidyl ether of alcohols such as butanediol, polyethylene glycol, and polypropylene glycol; a glycidyl ester-type epoxy resin, which is a glycidyl ester of a polyvalent carboxylic acid compound such as phthalic acid, isophthalic acid, or tetrahydrophthalic acid; a glycidylamine-type epoxy resin obtained by substituting active hydrogen bonded to a nitrogen atom of aniline, diaminodiphenylmethane, isocyanuric acid, or the like with a glycidyl group; a dicyclopentadiene-type epoxy resin obtained by epoxidizing a co-condensation resin of dicyclopentadiene and a phenol compound; an alicyclic-type epoxy resins such as vinylcyclohexene diepoxide, 3,4-epoxycyclohexylmethyl-3,4-epoxycyclohexanecarboxylate, and 2-(3,4-epoxy)cyclohexyl-5,5-spiro(3,4-epoxy)cyclohexane-m-dioxane obtained by epoxidizing an olefin bond in a molecule; a para-xylylene-modified epoxy resin, which is a glycidyl ether of para-xylylene-modified phenol resin; meta-xylylene-modified epoxy resin which is a glycidyl ether of meta-xylylene-modified phenol resin; a terpene-modified epoxy resin, which is a glycidyl ether of terpene-modified phenol resin; a dicyclopentadiene-modified epoxy resin, which is a glycidyl ether of dicyclopentadiene-modified phenol resin; a cyclopentadiene-modified epoxy resin, which is a glycidyl ether of cyclopentadiene-modified phenol resin; a polycyclic aromatic ring-modified epoxy resin, which is a glycidyl ether of polycyclic aromatic ring-modified phenol resin; a naphthalene-type epoxy resin, which is a glycidyl ether of naphthalene ring-containing phenol resin; a halogenated phenol novolac-type epoxy resin; a hydroquinone-type epoxy resin; a trimethylolpropane-type epoxy resin; a linear aliphatic epoxy resin obtained by oxidizing an olefin bond with a peracid such as peracetic acid; and an aralkyl-type epoxy resin obtained by epoxidizing an aralkyl-type phenol resin such as a phenol aralkyl resin or a naphthol aralkyl resin.

The compound (C) may be an aralkyl-type epoxy resin or an alicyclic-type epoxy resin, or may be a phenol aralkyl-type epoxy resin or 3,4-epoxycyclohexylmethyl-3,4-epoxycyclohexanecarboxylate.

In a case in which the photosensitive resin composition contains the compound (B), the aralkyl-type epoxy resin may be contained as the compound (C), or the compound (C) may not be contained. In a case in which the photosensitive resin composition does not contain the compound (B), the photosensitive resin composition may contain an alicyclic-type epoxy resin as the compound (C).

In a case in which the photosensitive resin composition contains the compound (C), the content of the compound (C) may be from 3% by mass to 50% by mass, from 5% by mass to 45% by mass, or from 8% by mass to 40% by mass with respect to a total amount of the photosensitive resin composition.

In a case in which the photosensitive resin composition contains an aralkyl-type epoxy resin as the compound (C), the content of the compound (C) may be from 3% by mass to 30% by mass, from 5% by mass to 20% by mass, or from 8% by mass to 15% by mass with respect to a total amount of the photosensitive resin composition.

In a case in which the photosensitive resin composition contains an alicyclic-type epoxy resin as the compound (C), the content of the compound (C) may be from 20% by mass to 50% by mass, from 30% by mass to 45% by mass, or from 35% by mass to 40% by mass with respect to a total amount of the photosensitive resin composition.

### (Polymerization Initiator (D))

The photosensitive resin composition of the present disclosure may contain a polymerization initiator (D). The kind of the polymerization initiator is not particularly limited, and examples thereof include a radical polymerization initiator that generates a radical by heat or light, an acid generator that generates an acid by heat or light, and a base generator that generates a base by heat or light. The radical polymerization initiator, the acid generator, and the base generator are not particularly limited, and conventionally known components can be used.

The polymerization initiator (D) may be used singly, or in a mixture of two or more kinds thereof.

For example, in a case in which the compound (B) is used, preferably, in a case in which a (meth)acrylate compound is further used as the compound (A), the photosensitive resin composition preferably contains a radical polymerization initiator as the polymerization initiator (D).

For example, in a case in which a phenol compound is used as the compound (A), preferably, in a case in which a phenol compound is used as the compound (A) and the compound (B) is not used, the photosensitive resin composition preferably contains an acid generator or a base generator as the polymerization initiator (D).

In a case in which the photosensitive resin composition contains the polymerization initiator (D), the content of the polymerization initiator (D) may be from 0.1% by mass to 5% by mass, from 0.3% by mass to 3% by mass, or from 0.5% by mass to 2% by mass with respect to the total amount of the photosensitive resin composition.

### (Maleimide Compound (E))

The photosensitive resin composition of the present disclosure may contain a maleimide compound (E) (hereinafter, also simply referred to as a "compound (E)"). By containing the maleimide compound (E), the integrated value of absorbance tends to further decrease.

The maleimide compound (E) may be used singly, or in a mixture of two or more kinds thereof.

The compound (E) preferably contains a bismaleimide compound, and more preferably contains an aromatic bismaleimide compound. For example, the compound (E) is preferably a maleimide compound represented by the following General Formula (E-1).

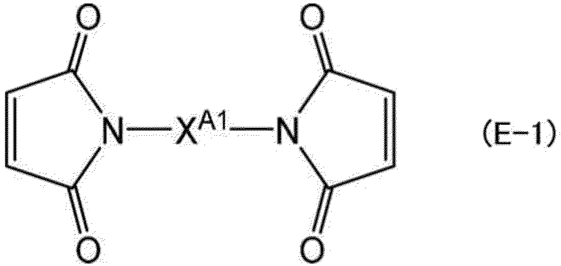

In General Formula (E-1), X^{A1} is a divalent organic group. X^{A1} may contain a phenylene group having a substituent.

X^{A1} may be a divalent organic group represented by the following General Formula (E-2).

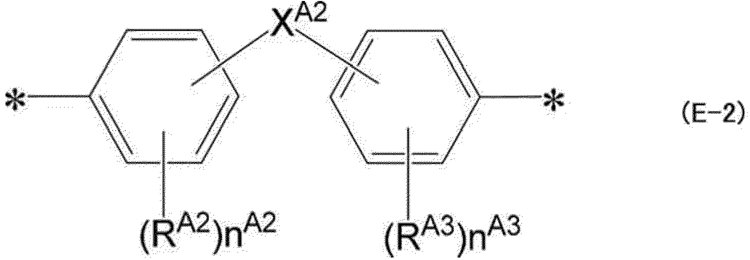

In General Formula (E-2), R^{A2} and R^{A3} are each independently an aliphatic hydrocarbon group having from 1 to 5 carbon atoms or a halogen atom. X^{A2} is a divalent organic group. n^{A2} and n^{A3} are each independently an integer of from 0 to 4. * represents a bonding site.

Examples of the divalent organic group in X^{A2} include an alkylene group having from 1 to 5 carbon atoms and a bisphenol skeleton (for example, a divalent linking group obtained by removing a hydrogen atom from each of two hydroxy groups) such as that of bisphenol A.

In a case in which the photosensitive resin composition contains the compound (E), the content of the compound (E) may be from 3% by mass to 30% by mass, from 5% by mass to 20% by mass, or from 8% by mass to 15% by mass with respect to a total amount of the photosensitive resin composition.

### (Modification Example)

A modification example of the photosensitive resin composition for an optical waveguide of the present disclosure may contain at least one compound selected from the group consisting of the compound (A), the compound (B), the compound (C), the polymerization initiator (D), and the compound (E) described above. The photosensitive resin composition for an optical waveguide may or may not satisfy an integrated value of absorbance of 3.0 or less at wavenumbers of from 9090 cm⁻¹ to 10526 cm⁻¹ at a thickness of 1 mm.

Preferred configurations of the compound (A), the compound (B), the compound (C), the polymerization initiator (D), and the compound (E) in the modification example are the same as those of the photosensitive resin composition for an optical waveguide of the present disclosure described above.

The photosensitive resin composition for an optical waveguide of the present disclosure and modification examples thereof may or may not contain components (hereinafter, also referred to as "other components") other than the compound (A), the compound (B), the compound (C), the polymerization initiator (D), and the compound (E) described above.

In the photosensitive resin composition for an optical waveguide of the present disclosure and the modification examples thereof, the content of other components may be 10% by mass or less, 5% by mass or less, or 1% by mass or less.

A lower limit of the content of other components is not particularly limited, and may be 0% by mass or more, or 0.1% by mass or more.

For example, a modification example of the photosensitive resin film of the present disclosure may be any one of the following photosensitive resin films 1 to 3.

A photosensitive resin film 1, which contains the compound (A), the compound (B), and the polymerization initiator (D).

A photosensitive resin film 2, which contains the compound (A), the compound (C), and the polymerization initiator (D).

A photosensitive resin film 3, which contains the compound (A), the compound (B), the compound (C), and the polymerization initiator (D).

The photosensitive resin films 1 to 3 may each independently contain the compound (E).

The photosensitive resin film 1 preferably contains a (meth)acrylate compound containing an acidic group as the compound (A), preferably contains a (meth)acrylate compound as the compound (B), and preferably contains a radical polymerization initiator as the polymerization initiator (D).

The photosensitive resin film 2 preferably contains a phenol compound as the compound (A), preferably contains an alicyclic-type epoxy resin as the compound (C), and preferably contains an acid generator or a base generator as the polymerization initiator (D).

The photosensitive resin film 3 preferably contains a (meth)acrylate compound containing an acidic group as the compound (A), preferably contains a (meth)acrylate compound as the compound (B), preferably contains an aralkyl-type epoxy resin as the compound (C), and preferably contains an acid generator or a base generator as the polymerization initiator (D).

### <Photosensitive Resin Film>

The photosensitive resin film of the present disclosure includes a photosensitive resin layer formed from the photosensitive resin composition for an optical waveguide of the present disclosure described above.

The photosensitive resin film is a formed product obtained by forming the photosensitive resin composition for an optical waveguide of the present disclosure into a film shape. For example, the photosensitive resin film is used for forming an insulating layer including an optical waveguide therein, and is used for forming at least one of a lower cladding layer, a core layer, or an upper cladding layer.

In the photosensitive resin film of the present disclosure, a photosensitive resin layer formed from the photosensitive resin composition for an optical waveguide of the present disclosure may be formed on a base material film layer, and a base material film layer and a protective film layer may be respectively formed on both surfaces of a photosensitive resin layer formed from the photosensitive resin composition for an optical waveguide of the present disclosure.

### <Optical Waveguide>

In an optical waveguide of the present disclosure, at least one selected from the group consisting of a lower cladding layer, a core layer, and an upper cladding layer is formed from the photosensitive resin composition for an optical waveguide of the present disclosure or the photosensitive resin film of the present disclosure.

As a result, it is possible to reduce the transmission loss at 1310 nm in the optical waveguide.

### <Optoelectronic Composite Substrate>

The optoelectronic composite substrate of the present disclosure includes the optical waveguide of the present disclosure. Hereinafter, an optoelectronic composite wiring board 30 will be described as an example of the optoelectronic composite substrate, and a semiconductor package 20 including the optoelectronic composite wiring board 30 will be described.

### [Semiconductor Package 20]

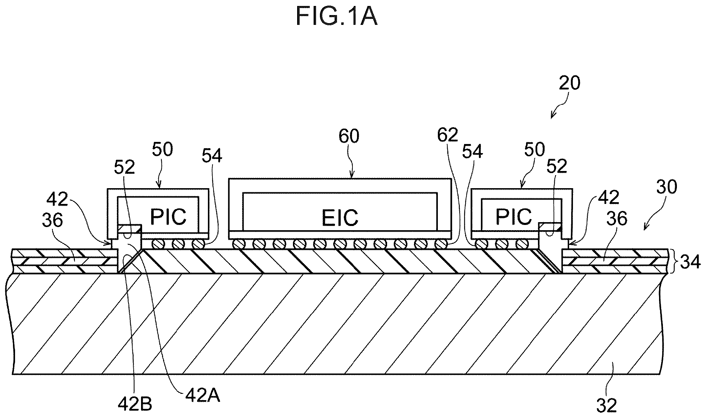

Fig. 1A is a schematic cross-sectional view illustrating an embodiment of a semiconductor package produced using the photosensitive resin composition of the present disclosure.

The semiconductor package 20 of the present disclosure includes the optoelectronic composite wiring board 30, an optical circuit chip 50, and an electronic circuit chip 60. The photosensitive resin composition of the present disclosure is a composition for use in forming an insulating layer 34 included in the optoelectronic composite wiring board 30, and is, for example, a composition for use in forming at least one of a lower cladding layer, a core layer, or an upper cladding layer.

### (Optoelectronic Composite Wiring Board 30)

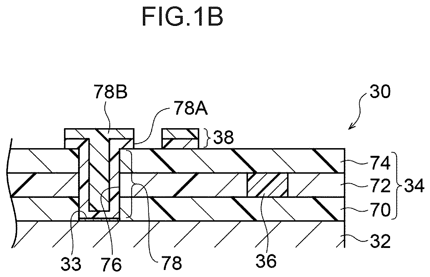

As illustrated in Figs. 1A and 1B, the optoelectronic composite wiring board 30 includes a resin layer, an optical wiring, and an electric wiring. Specifically, the optoelectronic composite wiring board 30 includes a substrate 32, the insulating layer 34, an optical waveguide 36 as an optical wiring, a wiring layer 38 as an electric wiring, and a via conductor 78 (see Fig. 1B).

The substrate 32 includes a wiring layer 33 (see Fig. 1B) as the electric wiring. In the present embodiment, as an example, the wiring layer 33 is provided on the surface of the substrate 32. The substrate 32 may be, for example, an inorganic base material such as glass and ceramic, an organic base material such as a copper-clad laminate, or a composite base material obtained by layering a prepreg, a build-up film, or a rewiring resin material thereon.

The insulating layer 34 is made of a resin material and is disposed on the substrate 32. Specifically, as illustrated in Fig. 1B, the insulating layer 34 is disposed on the substrate 32 and the wiring layer 33. The insulating layer 34 of the embodiment includes three layers as an example. The insulating layer 34 mainly includes a first layer 70 disposed on the substrate 32, a second layer 72 disposed on the first layer 70, and a third layer 74 disposed on the second layer 72. Note that the number of layers that constitute the insulating layer 34 is not limited to the above.

The optical waveguide 36 is a passage for guiding an optical signal, and is provided within the insulating layer 34 as illustrated in Figs. 1A and 1B. The optical waveguide 36 of the embodiment is configured by a part of the second layer 72 as an example. In addition, a light guide portion 42 is provided at an end of the optical waveguide 36. The light guide portion 42 includes a guide body 42A and a reflection mirror 42B. The light emitted from the end of the optical waveguide 36 is reflected by the reflection mirror 42B and travels to the optical circuit chip 50 through the guide body 42A. The light guide portion 42 is provided in the insulating layer 34.

The wiring layer 38 is provided inside the insulating layer 34 or on the surface of the insulating layer 34. As illustrated in Fig. 1B, the wiring layer 38 of the embodiment is provided on the surface of the insulating layer 34.

In a case in which there are a plurality of wiring layers 38, the wiring layer 38 may be provided inside the insulating layer 34 and on the surface of the insulating layer 34. In addition, each wiring layer may contain one kind or two or more kinds of metals. Examples of the metal that constitutes each wiring layer include copper, silver, gold, and aluminum. The metal that constitutes each wiring layer is not limited thereto.

A via conductor 40 electrically connects the wiring layer 33 and the wiring layer 38. In a case in which there are a plurality of wiring layers 38, the wiring layers 38 adjacent in the lamination direction may be electrically connected to each other by other via conductors. The metal that constitutes the via conductor may be the same as the metal that constitutes the wiring layer 38.

### (Optical Circuit Chip 50)

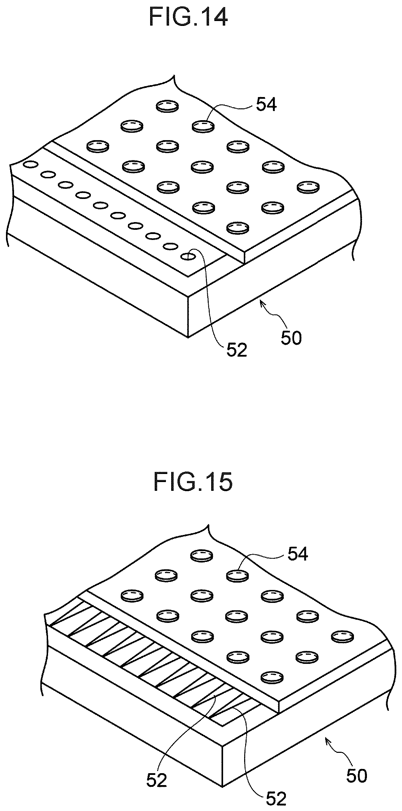

The optical circuit chip 50 is disposed on the optoelectronic composite wiring board 30. In addition, the optical circuit chip 50 is connected to the optical waveguide 36. Specifically, the optical circuit chip 50 is connected to the optical waveguide 36 via the light guide portion 42. Note that the optical circuit chip 50 has a light introduction port 52 (see Fig. 14) on an insulating layer 34 side, and the light guide portion 42 is connected to the light introduction port 52. A plurality of the light introduction ports 52 are provided at intervals in the optical circuit chip 50. In addition, an opening shape of the light introduction port 52 is not limited as long as light can be introduced, and may be a circular opening illustrated in Fig. 14 or a tapered shape illustrated in Fig. 15.

In addition, the optical circuit chip 50 is connected to a wiring layer for the optical circuit chip 50 in the insulating layer 34 via a chip electrode 54.

### (Electronic Circuit Chip 60)

The electronic circuit chip 60 is disposed on the wiring layer 38. In Fig. 1A, the illustration of the wiring layer 38 is omitted. The electronic circuit chip 60 is connected to the wiring layer 38 via a chip electrode 62.

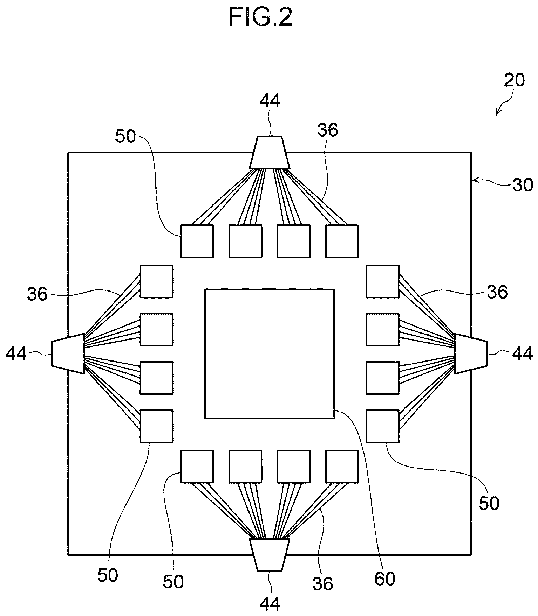

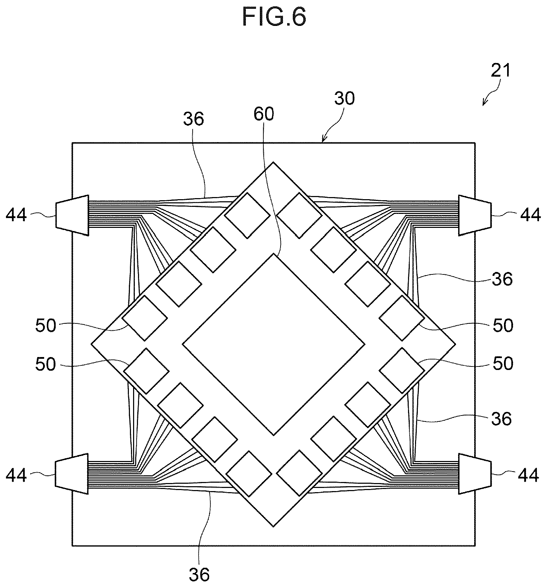

Fig. 2 is a schematic plan view of the semiconductor package illustrated in Fig. 1A. In the example of Fig. 2, the electronic circuit chip 60 is disposed at the center of the optoelectronic composite wiring board 30, and a plurality of optical circuit chips 50 are disposed so as to surround the electronic circuit chip 60. A plurality of optical waveguides 36 extending from an optical connector 44 provided in a peripheral portion of the optoelectronic composite wiring board 30 are connected to these optical circuit chips 50. In the example of Fig. 2, the optical connectors 44 are provided on four sides of the optoelectronic composite wiring board 30, but the present disclosure is not limited to the configuration. For example, as in the example illustrated in Fig. 6, one set of optical connectors 44 may be provided on each of two opposite sides of the optoelectronic composite wiring board 30.

In the semiconductor package 20, the optical circuit chip 50 and the electronic circuit chip 60 are disposed on the optoelectronic composite wiring board 30 without using a silicon interposer as a relay material. Therefore, the cost of the semiconductor package 20 is reduced as compared with that of a configuration using a silicon interposer.

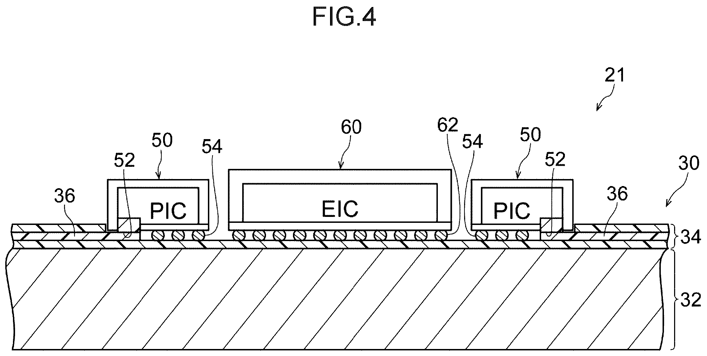

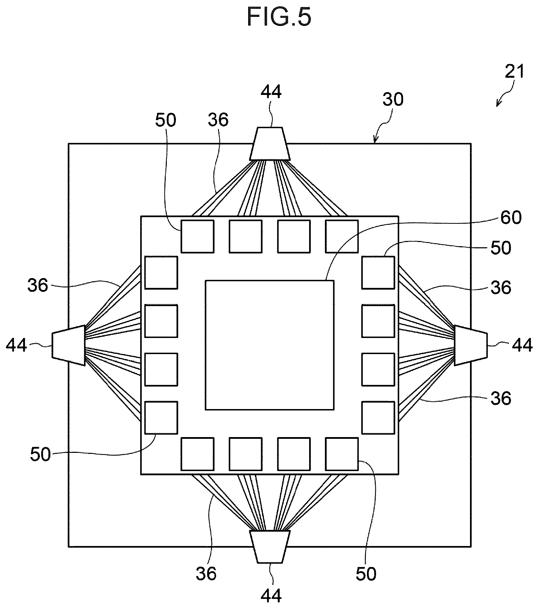

In the semiconductor package 20 described above, the optical waveguide 36 and the optical circuit chip 50 are connected via the light guide portion 42 as illustrated in Fig. 1A, but the present disclosure is not limited to the configuration. As in the semiconductor package 21 illustrated in Fig. 4, the light introduction port 52 may be directly connected to a portion that constitutes the optical waveguide 36. In the semiconductor package 21, the electronic circuit chip 60, the optical circuit chip 50, and the optical connector 44 may be arranged as in the example illustrated in Fig. 5, or the electronic circuit chip 60, the optical circuit chip 50, and the optical connector 44 may be arranged as in the example illustrated in Fig. 6.

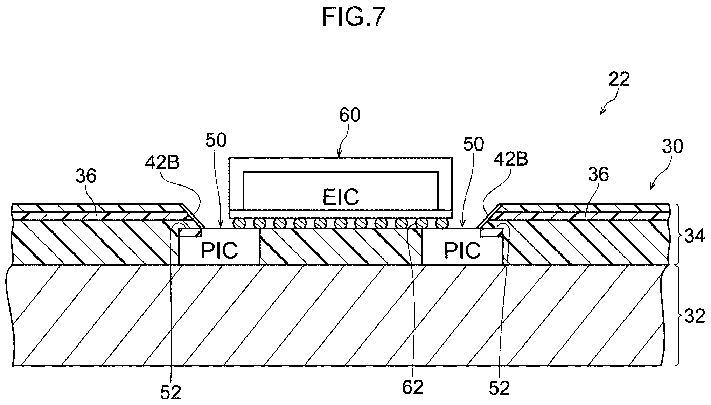

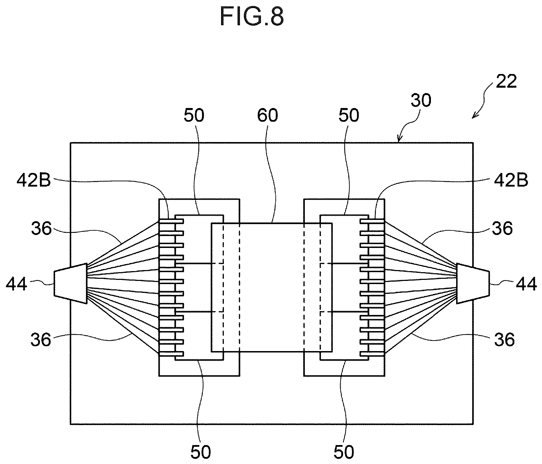

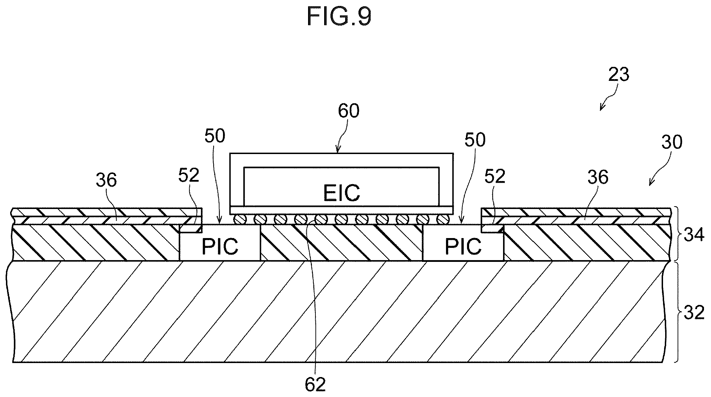

In the semiconductor package 20 described above, the optical circuit chip 50 is disposed on the optoelectronic composite wiring board 30 as illustrated in Fig. 1A, but the present disclosure is not limited to the configuration. As in the semiconductor package 22 illustrated in Fig. 7, the optical circuit chip 50 may be embedded in the insulating layer 34 that constitutes the optoelectronic composite wiring board 30. The reflection mirror 42B may be disposed at the end of the optical waveguide 36, and caused to reflect light toward the light introduction port 52 of the embedded optical circuit chip 50. In the semiconductor package 22, the electronic circuit chip 60, the optical circuit chip 50, and the optical connector 44 may be arranged as in the example illustrated in Fig. 8. Further, as in the semiconductor package 23 illustrated in Fig. 9, the optical waveguide 36 may be directly connected to a portion that constitutes the light introduction port 52.

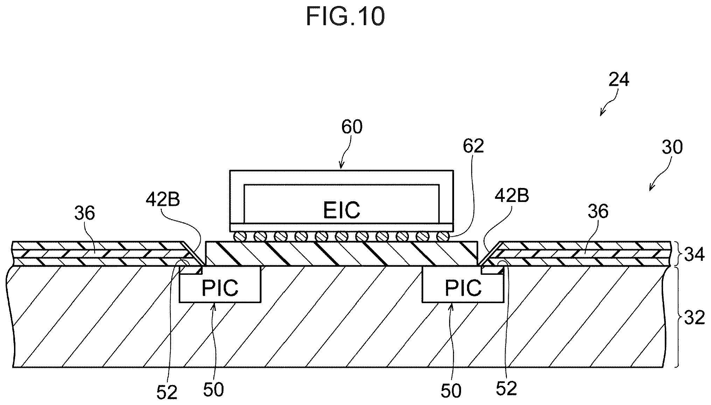

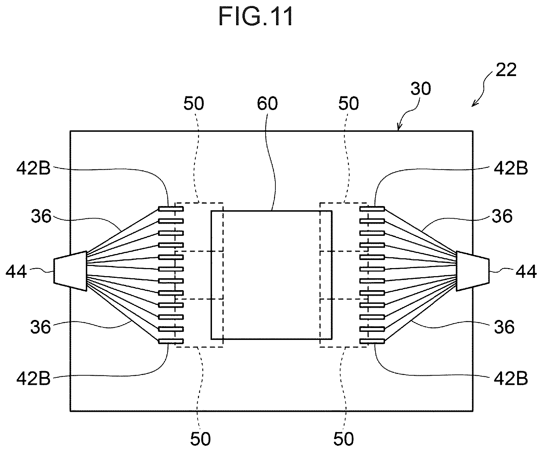

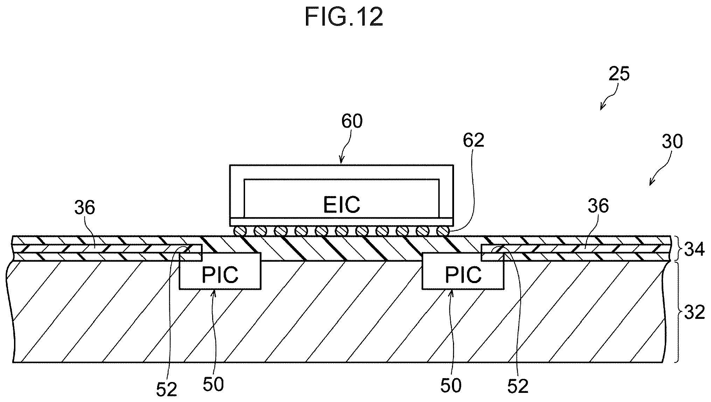

In the semiconductor package 22 described above, the optical circuit chip 50 is embedded in the insulating layer 34 that constitutes the optoelectronic composite wiring board 30, but the present disclosure is not limited to the configuration. As in the semiconductor package 24 illustrated in Fig. 10, the optical circuit chip 50 may be embedded in the substrate 32 that constitutes the optoelectronic composite wiring board 30. The reflection mirror 42B may be disposed at the end of the optical waveguide 36, and caused to reflect light toward the light introduction port 52 of the embedded optical circuit chip 50. In the semiconductor package 24, the electronic circuit chip 60, the optical circuit chip 50, and the optical connector 44 may be arranged as in the example illustrated in Fig. 11. Further, as in the semiconductor package 25 illustrated in Fig. 12, the optical waveguide 36 may be directly connected to a portion that constitutes the light introduction port 52.

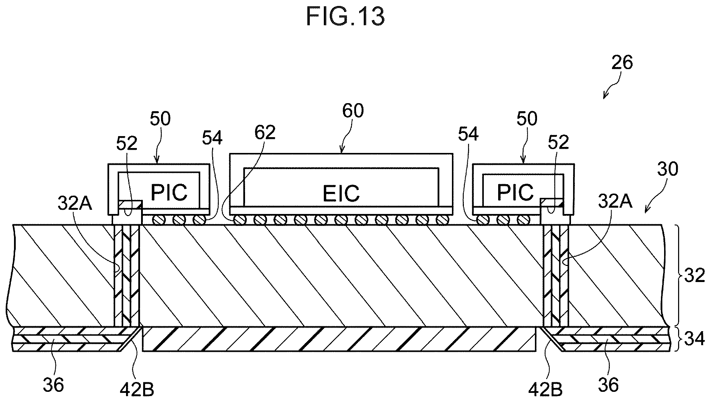

In the semiconductor package 22 described above, the optical circuit chip 50 and the electronic circuit chip 60 are disposed on the insulating layer 34 of the optoelectronic composite wiring board 30, but the present disclosure is not limited to the configuration. As in the semiconductor package 26 illustrated in Fig. 13, the optical circuit chip 50 and the electronic circuit chip 60 may be disposed on the surface of the substrate 32 opposite to the insulating layer 34. In this case, the substrate 32 is provided with a through hole 32A, the optical waveguide 36 passes through the through hole 32A, and the optical circuit chip 50 is arranged such that the light introduction port 52 is located at the end of the optical waveguide 36. As a result, the optical waveguide 36 is connected to the optical circuit chip 50.

Next, a method of manufacturing the optoelectronic composite wiring board 30 will be described.

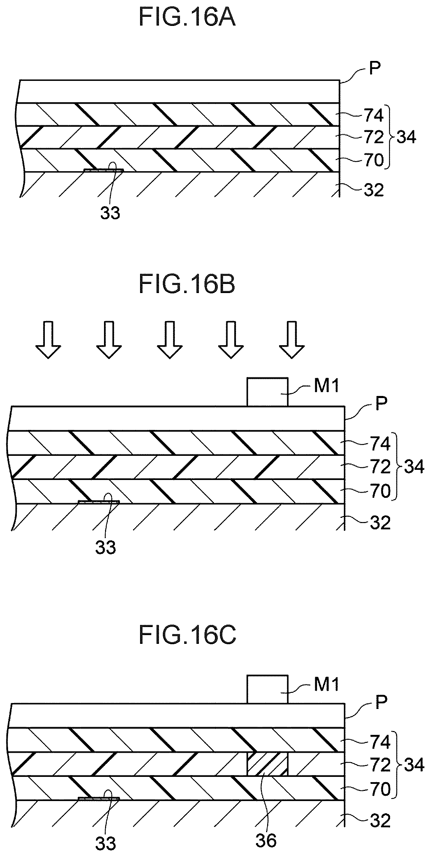

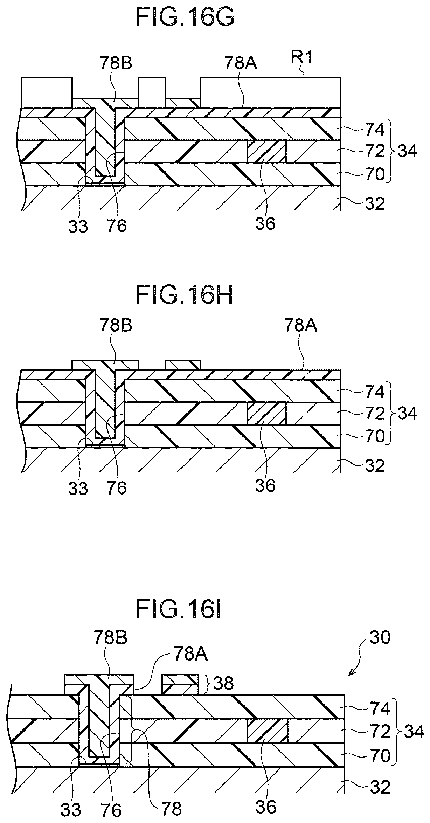

Figs. 16A to 16I are schematic cross-sectional views illustrating an embodiment of the method of manufacturing the optoelectronic composite wiring board 30.

As illustrated in Fig. 16A, the insulating layer 34 having a plurality of layers of different materials is formed on the substrate 32 having the wiring layer 33. In the embodiment, the first layer 70 (lower cladding layer) is disposed on the substrate 32, the second layer 72 (core layer) is disposed on the first layer 70, and the third layer 74 (upper cladding layer) is disposed on the second layer 72. At least one layer among the first layer 70, the second layer 72, or the third layer 74 is formed from the photosensitive resin composition of the present disclosure.

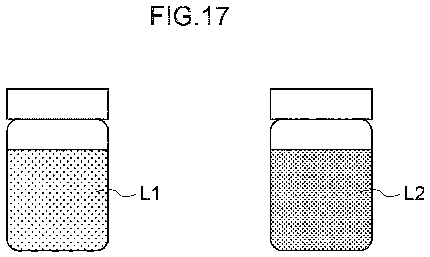

The insulating layer 34 may be formed by layering each layer that constitutes the insulating layer 34 on the substrate 32. For example, as illustrated in Fig. 17, the first layer 70 and the third layer 74 may be formed from a liquid resin material L1 (varnish), and the second layer 72 may be formed from another liquid resin material L2 (varnish). In this case, the insulating layer 34 is formed by applying the liquid resin material L1 onto the substrate 32, applying the resin material L2 onto the resin material L1 after curing the resin material L1, and applying the resin material L1 onto the resin material L2 after curing the resin material L2. At least one of the liquid resin material L1 or L2 may be the photosensitive resin composition of the present disclosure.

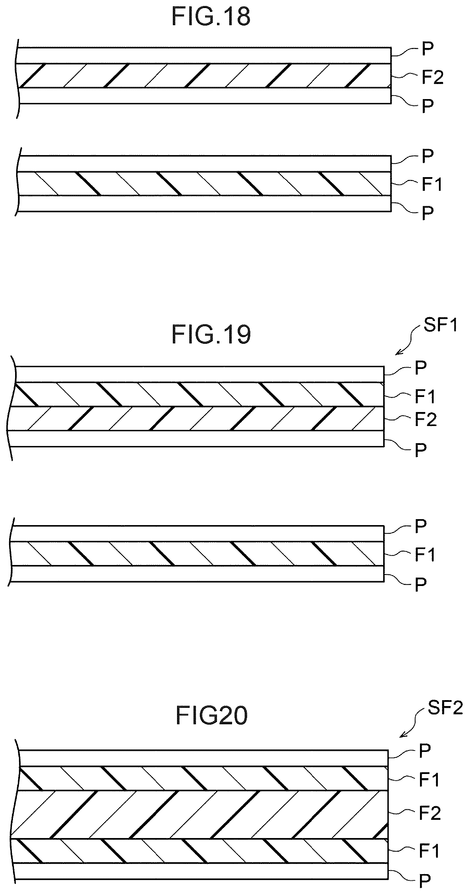

On the other hand, as illustrated in Fig. 18, the first layer 70 and the third layer 74 may be formed from a film-shaped resin material F1, and the second layer 72 may be formed from a film-shaped resin material F2. In this case, the insulating layer 34 is formed by disposing the film-shaped resin material F1 on the substrate 32, then disposing the resin material F2 on the resin material F1, and then disposing the resin material F1 on the resin material F2. A film-shaped protective material P may be provided on each of the two surfaces of the resin material F1. The protective materials P may also be provided on each of the two surfaces of the resin material F2. In a case in which the protective material P is provided on each of the two surfaces of the film-shaped resin material, the materials of the protective materials P may be different from each other. Specifically, one protective material P may be used to support the film-shaped resin material, and the other protective material P may be used to protect the surface of the film-shaped resin material.

The film-shaped resin material may be formed by applying a liquid resin material on the protective material P, or another protective material P may be placed on the applied resin material.

At least one of the film-shaped resin material F1 or F2 may be the photosensitive resin film of the present disclosure.

As illustrated in Fig. 19, a laminated film SF1 in which the film-shaped resin materials F1 and F2 that for the second layer 72 and the third layer 74 are layered may be used. In this case, since the number of protective materials P can be reduced, the cost can be easily reduced. In addition, the manufacturing efficiency is improved as compared with the case in which one layer is layered on the substrate 32.

Further, as illustrated in Fig. 20, a laminated film SF2 in which the film-shaped resin materials F1, F2, and F1 that respectively form the first layer 70, the second layer 72, and the third layer 74 are layered may be used. In this case, since the number of protective materials P can be further reduced, the cost can be easily reduced. In addition, the manufacturing efficiency is improved as compared with the case in which one layer is layered on the substrate 32.

As illustrated in Fig. 16B, a mask material M1 is then disposed on the insulating layer 34. Then, the insulating layer 34 is exposed. As illustrated in Fig. 16C, the second layer 72 that constitutes the insulating layer 34 is exposed by the exposure, and the optical waveguide 36 is formed. A portion of the second layer 72 that is not exposed by the mask material M1 becomes the optical waveguide 36. After the exposure of the insulating layer 34 is completed, the mask material M1 is removed from the insulating layer 34.

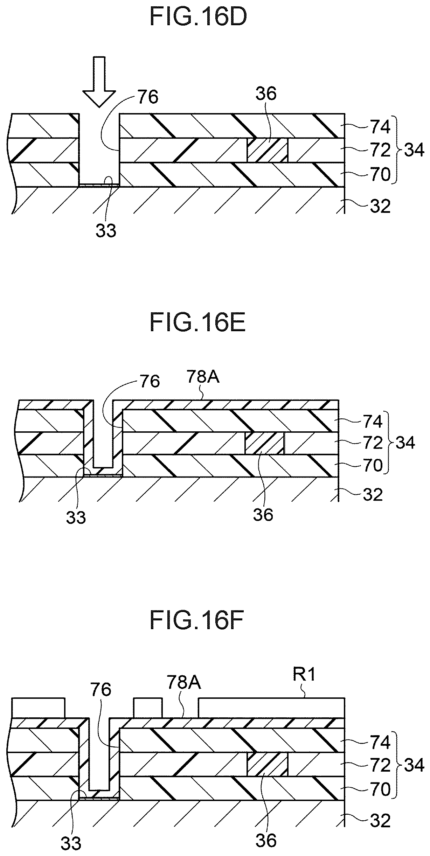

As illustrated in Fig. 16D, a via hole 76 is then formed in the insulating layer 34. The via hole 76 is a through hole continuously penetrating the first layer 70, the second layer 72, and the third layer 74. The via hole 76 may be formed by, for example, a drill, by laser irradiation, or by exposure and development.

The wiring layer 38 is then formed on the insulating layer 34, and the via conductor 78 that connects the wiring layer 33 and the wiring layer 38 is formed in the via hole 76. In order to form the via conductor 78, first, as illustrated in Fig. 16E, a seed layer 78A is disposed on the insulating layer 34, that is, on the third layer 74 (the surface of the third layer 74) and on the inner surface of the via hole 76. As shown in Fig. 16F, a resist material R1 is then disposed on the seed layer 78A. As shown in Fig. 16G, an electrolytic plating layer 78B is then disposed on the seed layer 78A. Thereafter, as shown in Fig. 16H, the resist material R1 is removed from above the seed layer 78A. Subsequently, a portion of the seed layer 78A not covered with the electrolytic plating layer 78B is removed. As a result, the via conductor 78 and the wiring layer 38 are formed. A portion in the via hole constitutes the via conductor 78, and a portion on the third layer 74 constitutes the wiring layer 33.

As described above, the optoelectronic composite wiring board 30 including the optical wiring and the electric wiring is manufactured.

Next, the laminated film will be described. As illustrated in Fig. 19, the laminated film SF2 includes a laminated body (insulating layer) having a first resin layer containing a substance whose refractive index is modulated by light irradiation and second resin layers respectively formed on both surfaces of the first resin layer and having a refractive index different from that of the first resin layer, and the protective materials P respectively provided on both surfaces of the laminated body and protecting the both surfaces. The first resin layer contains a thermosetting resin. The substance contained in the first resin layer may be a substance whose refractive index increases by light irradiation or a substance whose refractive index decreases by light irradiation. The second resin layer may contain a thermosetting resin. One of the two protective materials P may be used as a support film, and the other may be used as a protective film. Here, the support film is not particularly limited, and examples thereof include a polyester such as polyethylene terephthalate, polybutylene terephthalate, or polyethylene naphthalate; a polyolefin such as polyethylene or polypropylene; polycarbonate, polyamide, polyimide, polyamideimide, polyetherimide, polyether sulfide, polyether sulfone, polyether ketone, polyphenylene ether, polyphenylene sulfide, polyarylate, polysulfone, and liquid crystal polymer.

Among them, polyethylene terephthalate, polybutylene terephthalate, polyethylene naphthalate, polypropylene, polycarbonate, polyamide, polyimide, polyamideimide, polyphenylene ether, polyphenylene sulfide, polyarylate, and polysulfone are preferable from the viewpoint of flexibility and toughness.

Further, from the viewpoint of improving the transmittance of actinic rays for exposure and reducing the roughness of a side wall of the core pattern, it is more preferable to use a highly transparent support film. From the viewpoint of improving the peelability from the resin layer, a film subjected to a release treatment with, for example, a silicone-based compound or a fluorine-containing compound may be used if necessary.

The thickness of the support film may be appropriately changed depending on intended flexibility, but is preferably from 3 µm to 250 µm. In a case in which the thickness is 3 µm or more, the film strength is sufficient, and in a case in which the thickness is 250 µm or less, sufficient flexibility is obtained. From the above viewpoint, the thickness of the support film is more preferably from 5 µm to 200 µm, and even more preferably from 7 µm to 150 µm.

A photosensitive resin film produced by applying a photosensitive resin varnish or a photosensitive resin composition onto a support film may have a three-layer structure composed of the support film, the resin layer and the protective film by bonding a protective film onto the resin layer when necessary. The protective film is not particularly limited, and is suitably, for example, from the viewpoint of flexibility and toughness, a polyester such as polyethylene terephthalate, polybutylene terephthalate, or polyethylene naphthalate; and a polyolefin such as polyethylene or polypropylene. From the viewpoint of improving the peelability from the resin layer, a film subjected to a release treatment with, for example, a silicone-based compound or a fluorine-containing compound may be used if necessary. The thickness of the protective film may be appropriately changed depending on intended flexibility, and is preferably from 10 µm to 250 µm. In a case in which the thickness is 10 µm or more, the film strength is sufficient, and in a case in which the thickness is 250 µm or less, sufficient flexibility is obtained. From the above viewpoint, the thickness of the protective film is more preferably from 15 µm to 200 µm, and even more preferably from 20 µm to 150 µm.

In the present disclosure, a substrate having a plurality of insulating layers on a first wiring may be prepared, and the prepared substrate may be subjected to processing such as exposure.

Although the modes for carrying out the present disclosure have been described above with reference to the embodiments, these embodiments are merely examples, and various modifications can be made without departing from the gist of the present disclosure. It goes without saying that the scope of rights of the present disclosure is not limited to these embodiments.

### EXAMPLES

Hereinafter, the present invention will be specifically described with reference to Examples, but the invention is not limited to these Examples.

### <Preparation of Photosensitive Resin Composition for Optical Waveguide>

The components shown below were blended at the mixing proportions (parts by mass) shown in Table 1, and photosensitive resin compositions for optical waveguides of Examples and Comparative Examples were prepared. Blanks in Table 1 mean that the corresponding components are not blended.

### (Compound (A) Containing Acidic Group in One Molecule)

· Compound (A-1): Acid-modified epoxy acrylate (Trade name: KAYARAD UXE-3024, Nippon Kayaku Co., Ltd.)
· Compound (A-2): Cresol novolac resin (Trade name: TR4020G, ASAHI YUKIZAI Co., Ltd.)
· Compound (A-3): Novolac-type phenol resin (Trade name: PHENOLITE LA-7054, DIC Corporation)
· Compound (A-4): Cresol novolac resin (Trade name: EP6030G, ASAHI YUKIZAI Co., Ltd.)
· Compound (A-5): Acid-modified epoxy acrylate (Trade name: KAYARAD ZCR-1569, Nippon Kayaku Co., Ltd.)

### (Compound (B) Containing Ethylenically Unsaturated Group)

· Compound (B-1): Dipentaerythritol hexaacrylate
· Compound (B-2): Tris(2-acryloyloxyethyl) isocyanurate
· Compound (B-3): Trimethylolpropane trimethacrylate
· Compound (B-4): Cyclohexanedimethanol divinyl ether

### (Compound (C) Containing Epoxy Group)

· Compound (C-1): Phenol aralkyl-type epoxy resin (Trade name: NC-3000, Nippon Kayaku Co., Ltd.)
· Compound (C-2): 3,4-Epoxycyclohexylmethyl-3,4-epoxycyclohexanecarboxylate
· Compound (C-3): Hydrogenated epoxy resin (Trade name: jER YX8034, Mitsubishi Chemical Corporation)

### (Polymerization Initiator (D))

· Polymerization initiator (D-1): Phenyl bis(2,4,6-trimethylbenzoyl)phosphine oxide
· Polymerization initiator (D-2): Triphenylsulfonium hexafluoroantimonate (Maleimide Compound (E))
· Compound (E-1): 3,3'-Dimethyl-5,5'-diethyl-4,4'-diphenylmethane bismaleimide
· Compound (E-2): 2,2-Bis[4-(4-maleimidophenoxy)phenyl]propane

### <Evaluation of Photosensitive Resin Composition for Optical Waveguide>

An integrated value of absorbance at wavenumbers of from 9090 cm⁻¹ to 10526 cm⁻¹ was determined using each of the photosensitive resin compositions for optical waveguides of Examples and Comparative Examples. First, a photosensitive resin composition for an optical waveguide was formed by either of the following two methods, thereby preparing a sample for measuring absorbance.

The photosensitive resin composition for an optical waveguide was applied onto a glass substrate at a thickness of 1 mm. In a case in which the photosensitive resin composition for an optical waveguide contained an organic solvent, drying was performed at 100°C for 30 minutes after application to obtain a thickness of 1 mm after drying. The photosensitive resin composition for an optical waveguide applied to the glass substrate was irradiated with ultraviolet rays of 1000 mJ/cm³ using an aligner exposure apparatus (Mask aligner ML-320FSAT, manufactured by Mikasa Co., Ltd.), and then cured at 170°C for 1 hour, thereby obtaining a sample for absorbance measurement.

In a case in which the photosensitive resin composition for an optical waveguide containing an organic solvent was applied with a thickness of 100 µm onto a PET film, drying was performed at 100°C for 30 minutes after application, thereby obtaining a photosensitive resin film for an optical waveguide. The obtained photosensitive resin film was sequentially laminated on a glass substrate, thereby forming a photosensitive resin composition for an optical waveguide having a thickness of 1 mm on the glass substrate. The obtained photosensitive resin composition was irradiated with ultraviolet rays of 1000 mJ/cm³ using an aligner exposure apparatus (Mask aligner ML-320FSAT, manufactured by Mikasa Co., Ltd.), and then cured at 170°C for 1 hour, thereby obtaining a sample for absorbance measurement.

Using the sample for absorbance measurement, a near-infrared absorption spectrum was measured with an ultraviolet-visible near-infrared absorptiometer (UV-2600, manufactured by Shimadzu Corporation). In this case, it was confirmed that there was a positive correlation between the integrated value of absorbance at wavenumbers of from 9090 cm⁻¹ to 10526 cm⁻¹ and the absorbance at 1310 nm. Furthermore, a correlation between the integrated value of the absorbance and the ideal propagation loss at 1310 nm calculated from the absorbance at 1310 nm can also be confirmed, and it was found that the ideal propagation loss at 1310 nm can be reduced by reducing the integrated value of absorbance.

The results are shown in Table 1.

### <Evaluation of Alkali Developability>

A test piece having a photosensitive resin composition layer for an optical waveguide with a thickness of 50 µm was produced by applying the photosensitive resin composition for an optical waveguide onto a silicon wafer and drying at 100°C for 15 minutes, or by laminating, on a silicon wafer, a dry film prepared by applying the photosensitive resin composition for an optical waveguide onto a PET film and then drying at 100°C for 15 minutes. This test piece was immersed in a 2.38% aqueous tetramethylammonium hydroxide solution or a 1% aqueous sodium carbonate solution for 10 minutes, and then washed with distilled water for 5 minutes. As a result, when the photosensitive resin composition layer for an optical waveguide was dissolved and removed, and development was possible with either of the developers, it was rated as "A". When development was not possible with both of the developers, it was rated as "B".

The results are shown in Table 1.

### <Evaluation of Photosensitivity>

The photosensitive resin composition for an optical waveguide was applied onto a silicon wafer, and dried at 100°C for 15 minutes, thereby preparing a test piece having a photosensitive resin composition layer for an optical waveguide having a thickness of 50 µm. Alternatively, a dry film prepared by applying the photosensitive resin composition for an optical waveguide onto a PET film as a support was laminated on a silicon wafer, thereby preparing a test piece having a photosensitive resin composition layer for an optical waveguide having a thickness of 50 µm. A glass chromium-type photomask (having a wiring pattern having a line width/space width of 50 µm/50 µm) as a negative mask was provided on the photosensitive resin composition layer for an optical waveguide, and exposure was performed at a wavelength of 365 nm and an exposure amount of 1000 mJ/cm² using an aligner exposure apparatus (Mask aligner ML-320FSAT, manufactured by Mikasa Co., Ltd.).

After the exposure, in a case in which a PET film as a support was present in the photosensitive resin composition layer for an optical waveguide, the PET film was peeled off and the photosensitive resin composition layer for an optical waveguide was exposed. The exposed photosensitive resin composition layer for an optical waveguide was developed by being immersed in a 2.38% aqueous tetramethylammonium hydroxide solution or a 1% aqueous sodium carbonate solution for 10 minutes, and then washed with distilled water for 5 minutes. After development, when the unexposed portion was cleanly removed and no meandering or chipping occurred in the exposed portion, the evaluation of photosensitivity was rated as "A". When there was a portion not removed in the unexposed portion or meandering or chipping occurred in the exposed portion, the evaluation of photosensitivity was rated as "B".

The results are shown in Table 1.

**Table 1**

| Item | | Example 1 | Example 2 | Example 3 | Example 4 | Example 5 | Example 6 | Example 7 | Example 8 | Comparative Example 1 | Comparative Example 2 |
|---|---|---|---|---|---|---|---|---|---|---|---|
| Compound (A) containing acidic group in one molecule | Compound (A-1) | 60 | | 70 | 60 | 35 | | | 55 | | 30 |
| | Compound (A-2) | | 60 | | | | | | | 90 | |
| | Compound (A-3) | | | | | | | | | | 40 |
| | Compound (A-4) | | | | | 25 | | 50 | | | |
| | Compound (A-5) | | | | | | 40 | | | | |
| Compound (B) containing ethylenically unsaturated group | Compound (B-1) | 40 | | 20 | | | | 10 | | 10 | 20 |
| | Compound (B-2) | | | | 20 | 10 | | | 30 | | |
| | Compound (B-3) | | | | | | 30 | | | | |
| | Compound (B-4) | | | | | | | 10 | | | |
| Compound (C) containing epoxy group | Compound (C-1) | | | 10 | 10 | | | | | | 10 |
| | Compound (C-2) | | 40 | | | 30 | | | | | |
| | Compound (C-3) | | | | | | 20 | 30 | | | |
| Maleimide compound (E) | Compound (E-1) | | | | 10 | | 10 | | | | |
| | Compound (E-2) | | | | | | | | 15 | | |
| Polymerization initiator (D) | Polymerization initiator (D-1) | 1 | | 1 | 1 | | 1 | 1 | 1 | | 1 |
| | Polymerization initiator (D-2) | | 1 | | | 1 | | 1 | | 1 | |
| Integrated value of absorbance at wavenumbers of from 9090 to 10526 cm-¹ | | 2.15 | 2.42 | 2.00 | 1.84 | 2.84 | 1.46 | 2.75 | 1.87 | 3.10 | 3.20 |
| Ideal propagation loss (dB/cm) | | 0.40 | 0.49 | 0.39 | 0.36 | 0.47 | 0.41 | 0.48 | 0.37 | 0.65 | 0.60 |
| Developability | | A | A | A | A | A | A | A | A | A | B |
| Photosensitivity | | A | A | A | A | A | A | A | A | B | A |

As shown in Table 1, it was found that the ideal propagation loss at 1310 nm can be reduced by reducing the integrated value of absorbance described above.

Furthermore, in Examples 1 to 8, the evaluations of developability and photosensitivity were favorable.

The entire disclosure of Japanese Patent Application No. 2024-003395 filed on January 12, 2024 is incorporated herein by reference.

All documents, patent applications, and technical standards described herein are incorporated herein by reference to the same extent as if each individual document, patent application, and technical standard were specifically and individually identified to be incorporated by reference.

### Description of Reference Numerals

- 20, 21, 22, 23, 24, 25, 26: Semiconductor package
- 30: Optoelectronic composite wiring board
- 32: Substrate
- 32A: Through hole
- 33: Wiring layer
- 34: Insulating layer
- 36: Optical waveguide
- 38: Wiring layer
- 40: Via conductor
- 42: Light guide portion
- 42A: Guide body
- 42B: Reflection mirror
- 44: Optical connector
- 50: Optical circuit chip
- 52: Light introduction port
- 54: Chip electrode
- 60: Electronic circuit chip
- 62: Chip electrode
- 70: First layer
- 72: Second layer
- 74: Third layer
- 76: Via hole
- 78: Via conductor
- 78A: Seed layer
- 78B: Electrolytic plating layer
- F1: Resin material
- F2: Resin material
- L1: Resin material
- L2: Resin material
- M1: Mask material
- P: Protective material
- R1: Resist material
- SF1: Laminated film
- SF2: Laminated film

## Claims

1. A photosensitive resin composition for an optical waveguide, wherein an integrated value of absorbance at wavenumbers of from 9090 cm⁻¹ to 10526 cm⁻¹ at a thickness of 1 mm is 3.00 or less.

2. The photosensitive resin composition for an optical waveguide according to claim 1, comprising a compound (A) containing an acidic group in one molecule.

3. The photosensitive resin composition for an optical waveguide according to claim 1, comprising a compound (B) containing an ethylenically unsaturated group.

4. The photosensitive resin composition for an optical waveguide according to claim 1, comprising a compound (C) containing an epoxy group.

5. The photosensitive resin composition for an optical waveguide according to claim 1, comprising a polymerization initiator (D).

6. The photosensitive resin composition for an optical waveguide according to claim 1, comprising a maleimide compound (E).

7. A photosensitive resin film comprising a photosensitive resin layer formed from the photosensitive resin composition for an optical waveguide according to any one of claims 1 to 6.

8. A photosensitive resin film comprising:
a base material film layer; and
a photosensitive resin layer disposed on the base material film layer and formed from the photosensitive resin composition for an optical waveguide according to any one of claims 1 to 6.

9. A photosensitive resin film comprising, in this order:
a base material film layer;
a photosensitive resin layer formed from the photosensitive resin composition for an optical waveguide according to any one of claims 1 to 6; and
a protective film layer.

10. An optical waveguide, wherein at least one selected from the group consisting of a lower cladding layer, a core layer, and an upper cladding layer is formed from the photosensitive resin composition for an optical waveguide according to any one of claims 1 to 6.

11. An optical waveguide, wherein at least one selected from the group consisting of a lower cladding layer, a core layer, and an upper cladding layer is formed from the photosensitive resin film according to claim 7.

12. An optoelectronic composite substrate comprising the optical waveguide according to claim 10.

13. An optoelectronic composite substrate comprising the optical waveguide according to claim 11.
